**Europäisches Patentamt**

**European Patent Office**

**Office européen des brevets**

(19)

(11) Veröffentlichungsnummer: **0 299 275 B1**

## (12) EUROPÄISCHE PATENTSCHRIFT

(45) Veröffentlichungstag der Patentschrift: **11.03.92**

(51) Int. Cl.⁵: **H01L 25/10**, H02M 5/45

(21) Anmeldenummer: **88110308.9**

(22) Anmeldetag: **28.06.88**

(54) Stromrichteranlage zum Kuppeln zweier Hochspannungs-Drehstromnetze.

(30) Priorität: **13.07.87 DE 3723123**

(43) Veröffentlichungstag der Anmeldung:
**18.01.89 Patentblatt 89/03**

(45) Bekanntmachung des Hinweises auf die
Patenterteilung:
**11.03.92 Patentblatt 92/11**

(84) Benannte Vertragsstaaten:
**AT DE FR GB SE**

(56) Entgegenhaltungen:
**EP-A- 0 151 271**
**FR-A- 2 452 853**

(73) Patentinhaber: **SIEMENS AKTIENGESELL-SCHAFT**
**Wittelsbacherplatz 2**
**W-8000 München 2(DE)**

(72) Erfinder: **Wiendl, Heinz, Dipl.-Ing.**
**Georg-Ledebour-Strasse 36**
**W-8500 Nürnberg 50(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

**Beschreibung**

Die Erfindung betrifft eine Stromrichteranlage zum Kuppeln zweier Hochspannungs-Drehstromnetze gemäß dem Oberbegriff des Patentanspruchs 1.

Um zwei Netze mit unterschiedlichem Frequenzverhalten (asynchrone Netze) zwecks Stromaustausch miteinander zu kuppeln, wird zwischen den beiden miteinander zu verbindenden Netzen ein entkoppelter Gleichstromkreis in Form eines Drehstrom-Gleichstrom-Drehstromumsetzers angeordnet. Nachdem die Hochspannungs-Gleichstromübertragung praktisch mit der Entfernung Null erfolgt, bezeichnet man diesen Gleichstromkreis als "Gleichstrom-Kurzkupplung".

Eine solche Gleichstrom-Kurzkupplung ist aus "Österreichische Zeitschrift für Elektrizitätswirtschaft", JG 36, Heft 8/9, Seite 265 ff bekannt. Die dort beschriebene Anordnung besitzt im wesentlichen zwei gleichstromseitig miteinander verbundenen, drehstromseitig an die beiden Netze angeschlossene Drehstrom-Vollweg-Stromrichteranordnungen, die anstelle von passiven Gleichrichterventilen steuerbare Gleichrichterbauelemente (Thyristoren) enthalten. Dies ermöglicht einen Stromaustausch zwischen den beiden gekoppelten Netzen wahlweise in beiden Richtungen. Dabei ist die dem speisenden Netz zugeordnete Stromrichteranordnung als Gleichrichter und die dem eingespeisten Netz zugeordnete Stromrichteranordnung als Wechselrichter betrieben. Die Steuerung der Thyristoren erfolgt über eine zentrale Thyristorelektronik, bei der jedem Thyristor eine Thyristorelektronik-Baugruppe zugeordnet ist, die aus einem Leistungsteil für die Bildung und Abgabe eines elektrischen Zündimpulses, einer informationsverarbeitenden Elektronik sowie einer Signalübertragungseinheit besteht. Die Signalübertragung erfolgt über Lichtleiterkabel.

Bei einer aus der DE-OS 34 04 076 bekannten weiteren Anordnung arbeiten je zwei, einem Netz zugeordnete Stromrichtertransformatoren, von deren Sekundärwicklungen eine in Stern und die andere in Dreieck geschaltet sind, auf einen Drehstrom-Vollweg-Gleichrichter mit zwölf Halbleiter-Gleichrichter-Bauelementen. Jeder der drei sekundären Drehstromphasen der beiden als Stromrichtertransformatorenarbeitenden Drehstromtransformatoren sind also je zwei hintereinandergeschaltete Halbleiterbauelemente zugeordnet, so daß je vier Halbleiter-Bauelemente eine Halbleiter-Baugruppe bilden. Dabei besteht jedes Halbleiter-Bauelement aus zwei hintereinandergeschalteten Thyristoren. Diese Halbleiter-Baugruppen werden üblicherweise übereinander angeordnet und bilden zusammen einen sogenannten Ventilturm. Um nun die Grundfläche für die sogenannte Ventilhalle, in der die Ventiltürme untergebracht sind, möglichst klein zu halten, ist gemäß der DE-OS 34 04 076 die Anordnung der Ventiltürme so getroffen, daß jede der den vier Sekundärwicklungen der Stromrichtertransformatoren zugeordneten Halbleiter-Baugruppen einen Ventilturm bilden. Diese Anordnung erfordert also nur vier Ventiltürme, so daß die Ventilhalle wegen der relativ kurzen Signalübertragungsstrecken ohne Unterkellerung für die Steuerungselektronik, die auch als Fußpunktelektronik bezeichnet wird, auskommt. Kurze Signalübertragunswege sind deshalb notwendig, weil die Signalübertragung über Lichtleiter erfolgt und die zwischenverstärkerfreien Übertragunslängen bei Lichtleiterkabeln auf ca. 30 m begrenzt sind.

Diese bekannte Anordnung erfüllt ihren Zweck bei relativ niedrigen Übertragungsleistungen gut. Bei höheren Übertragungsleistungen stößt diese Anordnung allerdings an die Grenze ihrer Wirtschaftlichkeit. Es kommt hinzu, daß man dazu übergegangen ist, Ventiltürme der vorbeschriebenen Art aus einheitlichen Ventilbaugruppen (Modulen) bausteinartig zusammenzusetzen. Diese Technik ist aus der DE-OS 36 05 337 bekannt. Wenn man nun die aus der DE-OS 34 04 076 bekannte Anordnung mit solchen Modulen aufbaut und die Übertragungsleistung erhöht werden soll, was bedeutet, daß auch die Anzahl der Module vergrößert werden muß, ergibt sich das Problem, daß mit steigender Übertragungsleistung auch höhere Isolierabstände zwischen den einzelnen Modulen gewählt werden müssen. Dies hängt mit der besonderen Schaltungsanordnung des Gegenstandes dieses Standes der Technik zusammen, bei dem die jeweils einer Drehstrom-Sekundärwicklung zugeordneten Stromrichter jeweils einen Turm bilden, so daß die Spannung zwischen den einzelnen Etagen dem Spitzenwert der jeweiligen Wechselspannung entspricht, die ja um den Faktor 2 höher ist, als die Effektivspannung.

Der Erfindung liegt die Aufgabe zugrunde, Ventiltürme zu bilden, deren einzelne Etagen als Thyristorbaugruppen in Modulbauweise in einer der gewünschten Durchgangsleistung entsprechenden Zahl in der Weise aufeinandergesetzt werden können, daß die Isolierabstände zwischen den Etagen unabhängig von der jeweils ausgelegten Durchgangsleistung gleichbleiben, daß die Länge der als Lichtleiter ausgebildeten Steuerleitungen eine zulässige Größe nicht überschreitet und daß schließlich die wechselstromseitigen Anschlußleitungen zwischen den Ventiltürmen und den Hallendurchführungen der Sekundäranschlüsse der Transformatoren möglichst kurz sind und nicht überkreuzt geführt werden müssen.

Diese Aufgabe wird durch die im Patentanspruch 1 angegebene Erfindung gelöst. Dadurch ist erreicht, daß Kurzkupplungen für unterschiedliche Leistungen nach dem gleichen konstruktiven Konzept errichtet werden können, so daß die jeweilige Leistungsanpassung durch eine entsprechende Anzahl der einen Turm bildenden Module mit gleichen Isolierabständen vorgenommen werden kann und somit eine weitgehend standardisierte Bauweise bei solchen Kurzkupplungen erreicht ist. Dabei bleiben auch die Leitungslängen für die Glasfaser-Steuerkabel bis zu einer Gesamtdurchgangsleistung von 500 MW genügend kurz, um eine kellerfreie Bauweise zu gestatten. Außerdem ist durch die konsequente Modulbauweise erreicht, daß man mit einem Hallenkran von maximal 1 t Tragkraft auskommt und sich Reperaturarbeiten auf einen Austausch standardisierter Bauelemente beschränken können, so daß beo kleiner Ersatzteillagerkapazität auch die Ausfallzeiten bei Reparaturen gering bleiben.

Ein Ausführungsbeispiel der Erfindung wird anhand von Zeichnungen im folgenden näher erläutert. Es zeigen:

FIG 1      ein Übersichtsschaltbild einer Hochspannungs-Gleichstrom-Kurzkupplung für die Verknüpfung zweier asynchroner Hochspannungsnetze;

FIG 2      eine schematische Darstellung der zweietagigen 12 Ventiltürme;

FIG 3      eine Grundrißdarstellung einer Ventilhalle für eine Durchgangsleistung von 500 MW in Draufsicht bei geöffnetem Dach;

FIG 4      die gleiche Halle in schnittbildlicher Seitenansicht und

FIG 5      in schnittbildlicher Vorderansicht.

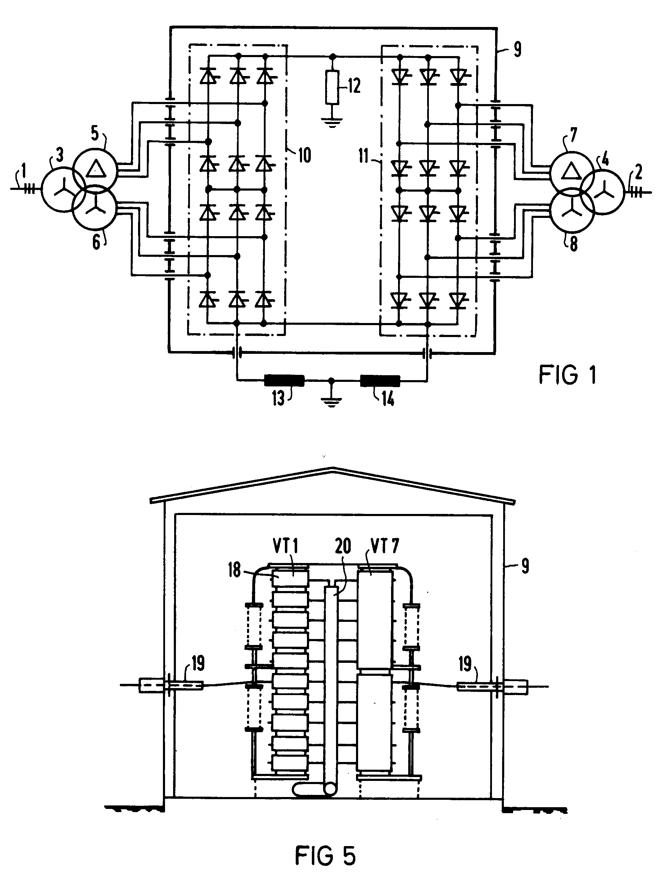

Gemäß dem Übersichtsschaltbild nach FIG 1 sind die Drehstromfreileitungen der miteinander zu verbindenden asynchronen Drehstromnetze 1, 2 an die Primärwicklungen der zugeordneten Drehstrom-Transformatoren 3, 4 geführt. Deren Sekundärwicklungen 5, 6 und 7, 8 sind über Zuleitungen R1, S1, T1; R2, S2, T2; R3, S3, T3 sowie R4, S4, T4 von außen über Durchführungen durch gegenüberliegende Wände der Ventilhalle 9 nach innen zu den zugeordneten Ventilgruppen der beiden 12-Puls-Gleichrichterbrükkenschaltungen geführt. Jeweils eine der beiden Sekundärwicklungen der den beiden Netzen 1, 2 zugeordneten Transformatoren ist in Stern und die andere in Dreieck geschaltet. Die beiden Gleichrichterschaltungen 10, 11 sind gleichspannungsseitig mit ihren über einen Spannungsteiler 12 geerdeten Minuspolen unmittelbar und mit den Pluspolen über Glättungsdrosseln 13, 14, deren Verbindungsleitung ebenfalls geerdet ist, miteinander verbunden. Diese Glättungsdrosseln 13, 14 dienen einerseits zum Herabsetzen der Gleichstromwelligkeit, andererseits zum Begrenzen des Kurzschlußstromes bei Ventilkurzschlüssen. Die Schaltung selbst ist bekannt und bedarf keiner näheren Erläuterung.

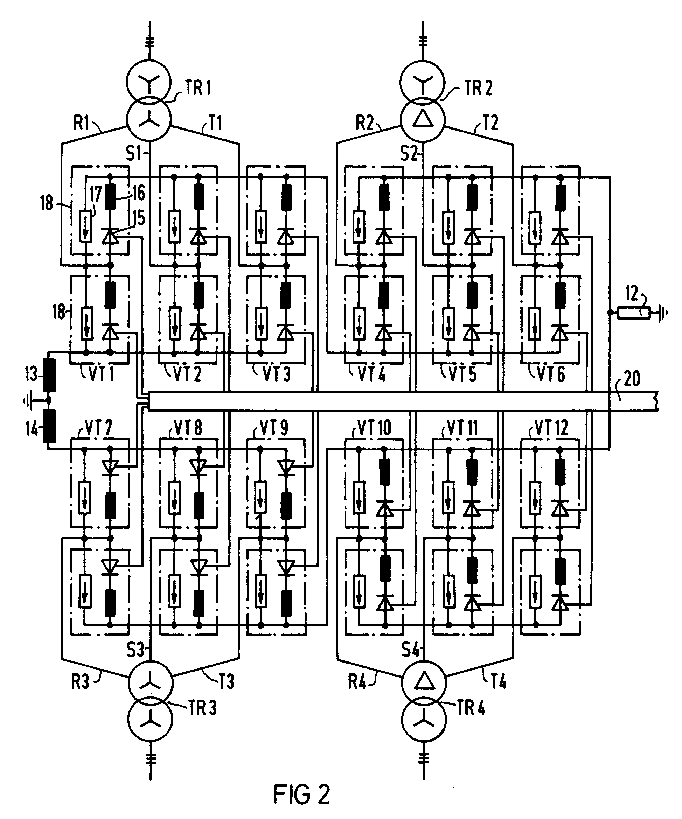

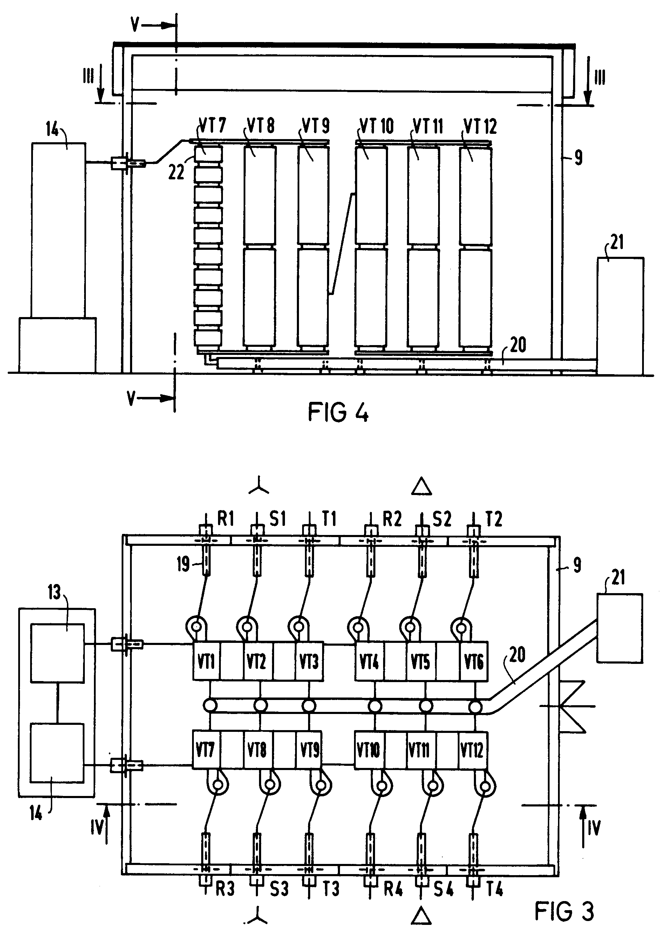

In FIG 2 ist nun gezeigt, wie die aus Thyristoren 15, Ventildrosseln 16 und Überspannungsableitern 17 aufgebauten Thyristorbaugruppen in Form von Modulen 18 (dargestellt sind der Einfachheit halber nur jeweils zwei Module pro Turm) als Etagen von insgesamt 12 Ventiltürmen VT1 bis VT12 im Prinzip aufgebaut sind. Die elektrische Schaltung entspricht derjenigen nach FIG 1 und bedarf keiner näheren Erläuterung. Den Ventiltürmen VT1, VT2 und VT3 sind die Anschlußleitungen R1, S1, T1 des Transformators TR1 zugeordnet, die an den betreffenden Trum in dessen vertikaler Mitte angeschlossen sind. Den Türmen VT4, VT5 und VT6 ist der Transformator TR2; den Türmen VT7, VT8 und VT9 der Transformator TR3 und den Türmen VT10, VT11 und VT12 der Transformator TR4 entsprechend zugeordnet. Durch diese Art der Turmbildung und der Anschlüsse in der vertikalen Mitte der Türme kann die Installation der Wechselstromzuleitungen elektrisch besonders günstig vorgenommen werden. Die Durchführungsisolatoren 19 (FIG 3) der Sekundäranschlüsse der Transformatoren können alle in der gleichen Ebene in etwa gleichen Abständen in die Hallenwände verlegt werden, so daß die kürzest möglichen Verbindungsleitungen zwischen den Transformatoren und den Gleichrichtertürmen gegeben sind. Auch die Art der Anschlüsse der einzelnen Ventiltürme auf halber Höhe führt zu besonders kurzen, kreuzungs- und umlenkungsfreien Wechselstromverbindungen. Dadurch werden die elektrischen und magnetischen Wechselwirkungen zwischen den Zuleitungen auf ein Minimum begrenzt.

Diese räumlich günstige Anordnung zeigt sich besonders deutlich in der Draufsicht auf die Ventilhalle in FIG 3. Daraus ist auch zu erkennen, daß die zu einem Lichtleiterkabel 20 zusammengefaßten Steuerleitungen zu den einzelnen Thyristoren auf besonders günstige Weise in die Mitte zwischen die beiden Ventilturmreihen VT1 bis VT6 und VT7 bis VT12 und nach außen zu der zentralen Steuerelektronik (Fußpunktelektronik) 21 gut zugänglich verlegt werden können.

Der Längsschnitt durch die Ventilhalle 9 in FIG 4 läßt erkennen, daß auch die gleichstromseitige Leitungsführung zu den außen angeordneten Glättungsdrosseln 13, 14 mit einer kurzen, geradlinig geführten Leitung erfolgen kann, die sich nicht mit der Wechselstromseite kreuzt.

In FIG 5 wird deutlich, daß die Durchführungsisolatoren 19 etwa in gleicher Höhe der Wechselstromanschlüsse der Gleichrichtertürme liegen und damit eine besonders kurze Leitungsführung ermöglichen. In den Figuren 4 und 5 ist auch die modulare Bauweise der Türme gut zu erkennen. Jeder der Türme besteht aus zehn Etagen (Modulen 18) identischen Aufbaues und gleicher Isolierabstände voneinander und von den Nachbartürmen. Der gezeigte Aufbau mit zehn Modulen pro Turm entspricht einer Durchgangsleistung von 500 MW. Die Lichtleiterkabel haben dabei eine maximale Länge bis zur Fußpunktelektronik 21 von ca. 35 m. Dies ermöglicht einen kostengünstigen kellerfreien Aufbau der Ventilhalle und eine störungssichere Anordnung der Fußpunktelektronik außerhalb der Ventilhalle.

## Patentansprüche

1. Stromrichteranlage zum Kuppeln zweier Hochspannungs-Drehstromnetze, bestehend aus einer jedem der zu kuppelnden Netze zugeordneten Drehstrom-Vollweg-Stromrichteranordnung mit je einem Drehstromtransformator, von denen der eine sekundärseitig in Stern und der andere in Dreieck geschaltet ist, und steuerbaren Halbleitern, die von einer zentralen Steuerungselektronik so gesteuert werden, daß die eingangsseitige Stromrichteranordnung als Gleichrichter und die ausgangsseitige Stromrichteranordnung als Wechselrichter arbeitet, und die steuerbaren Halbleiter in Form von einheitlichen Funktionsgruppen in Modulbauweise, bestehend aus einem Halterungsrahmen, der je eine Ventildrossel und eine gleiche Anzahl von Thyristoren beinhaltet und mit elektrischen Anschlußelementen sowie Halterungselementen für die Befestigung der Abstandsisolatoren versehen ist, derart übereinander angeordnet sind, daß gleichartig aufgebaute Stromrichtertürme (Ventiltürme) gebildet werden, die gleichstromseitig gleichpolig untereinander und drehstromseitig mit den zugeordneten in Stern und Dreieck geschalteten Sekundärwicklungen der Drehstromtransformatoren verbunden sind, **dadurch gekennzeichnet,** daß die jeder sekundärseitigen Drehstromphase (R, S, T) jedes Drehstromtransformators (TR1 bis TR4) zugeordneten Gleichrichterbrückenzweige einen eigenen Turm (VT1 bis VT12) bilden, der aus einer leistungsabhängigen Anzahl von mit gleichem Isolierabstand übereinander angeordneter Etagen (18) besteht, die aus modularen Funktionsgruppen (15, 16, 17) gebildet sind.

## Claims

1. Power converter system for coupling two high-voltage three-phase networks, consisting of a three-phase current full-wave converter arrangement, associated with each of the networks to be coupled, with respectively one three-phase current transformer, of which the one is star-connected on the secondary side and the other is delta-connected, and of controllable semiconductors which are controlled by a central control electronics unit such that the converter arrangement on the input side operates as a rectifier and the converter arrangement on the output side operates as an inverter and the controllable semiconductors in the form of uniform functional groups of modular construction, consisting of a supporting frame, containing, in each case, a valve reactor and an equal number of thyristors and being provided with electrical connection elements and also support elements for fixing the stand-off insulators, are arranged one upon the other such that converter towers (valve towers) set up in a similar manner are formed, which towers are connected on the direct current side, in a homopolar manner, one with the other and on the three-phase current side with the associated star- and delta-connected secondary windings of the three-phase current transformers, **characterised in that** the rectifier bridge branches associated with each secondary-side three-phase current phase (R, S, T) of each three-phase current transformer (TR1 to TR4) form an individual tower (VT1 to VT12) consisting of an output-dependent number of tiers which are arranged one upon the other with equal insulating clearance and are formed of modular functional groups (15, 16, 17).

## Revendications

1. Installation à convertisseurs statiques servant à accoupler deux réseaux triphasés à haute tension, constituée par des dispositifs convertisseurs statiques triphasés double alternance, associés respectivement aux réseaux devant être accouplés et comportant des transformateurs d'intensité triphasés respectifs, dont l'un est branché en étoile côté secondaire et dont l'autre est branché en triangle, et par des semiconducteurs commandables, qui sont commandés par une unité électronique centrale de commande de telle sorte que le dispositif convertisseur statique situé sur le côté entrée fonctionne en tant que redresseur et le dispositif convertisseur statique situé côté sortie fonctionne en tant qu'onduleur, et les semiconducteurs commandables réalisés sous la forme de groupes fonctionnels uniformes de conception modulaire, constitués par un cadre de fixation, qui contient respectivement une inductance de valve et un même nombre de thyristors et est équipé d'éléments électriques de raccordement ainsi que d'éléments de fixation pour la fixation des isolateurs, sont disposés de manière à former des piles de convertisseurs statiques (piles de valves) possédant des constitutions identiques et qui sont raccordées entre elles par leurs pôles de même nom, du côté du courant continu, et sont raccordées, du côté du courant triphasé, à des enroulements secondaires associés, branchés en étoile et en triangle, du transformateur de courant triphasé, caractérisée par le fait que les branches des ponts des redresseurs, associées à chaque phase (R,S,T) de courant triphasé, située sur le côté secondaire, de chaque transformateur de courant triphasé (TR1 à TR4), forment une pile particulière (VT1 à VT12), qui est constituée par un nombre, qui dépend de la puissance, d'étages (18), qui sont superposés en étant séparés par la même distance d'isolement et sont formés par des groupes fonctionnels modulaires (15,16,17).

FIG 1

FIG 5

FIG 2

FIG 4

FIG 3

8